Europäisches Patentamt

European Patent Office

Office européen des brevets

(11) Numéro de publication: **0 206 929**
**B1**

(12) **FASCICULE DE BREVET EUROPEEN**

(45) Date de publication du fascicule du brevet:
06.09.89

(51) Int. Cl.⁴: **H01L 21/82,** H01L 29/60

(21) Numéro de dépôt: **86401321.4**

(22) Date de dépôt: **17.06.86**

(54) **Procédé de fabrication d'un circuit intégré et notamment d'une mémoire eprom comportant deux composants distincts isolés électriquement.**

(30) Priorité: **21.06.85 FR 8509486**

(43) Date de publication de la demande:
**30.12.86 Bulletin 86/52**

(45) Mention de la délivrance du brevet:
**06.09.89 Bulletin 89/36**

(84) Etats contractants désignés:
**BE CH DE GB IT LI NL**

(56) Documents cités:
**FR-A- 2 513 793**
**GB-A- 2 080 024**

**PATENTS ABSTRACTS OF JAPAN,**
**vol. 8, no. 21 (E-224)[1458], 28 janvier 1984 & JP - A**
**- 58 184 768**
**PATENTS ABSTRACTS OF JAPAN,**
**vol. 8, no. 39 (E-228)[1476], 21 février 1984 & JP - A**
**- 58 197 776**

(73) Titulaire: **COMMISSARIAT A L'ENERGIE ATOMIQUE,**
**29-31, rue de la Fédération, F-75015 Paris(FR)**

(72) Inventeur: **Hartmann, Joel, 13, rue de la Balmette,**
**F-38640 Claix(FR)**
Inventeur: **Martin, François, 17, rue Docteur Calmette,**
**F-38000 Grenoble(FR)**

(74) Mandataire: **Mongrédien, André et al, c/o**
**BREVATOME 25, rue de Ponthieu, F-75008 Paris(FR)**

## Description

La présente invention a pour objet un procédé de fabrication d'un circuit intégré comportant deux types de composants distincts isolés électriquement. Ce procédé permet la fabrication d'un circuit mémoire, notamment une mémoire EPROM, c'est-à-dire d'une mémoire électriquement programmable à lecture seulement effaçable par un rayonnement ultraviolet.

Une mémoire EPROM est un circuit intégré comportant une partie mémoire proprement dite formée de plusieurs cellules mémoires ou points mémoires réalisés avec un premier type de composant et des circuits périphériques réalisés avec un deuxième type de composant permettant de commander les cellules mémoires ; la partie mémoire et les circuits périphériques sont réalisés sur un même substrat suivant des technologies différentes.

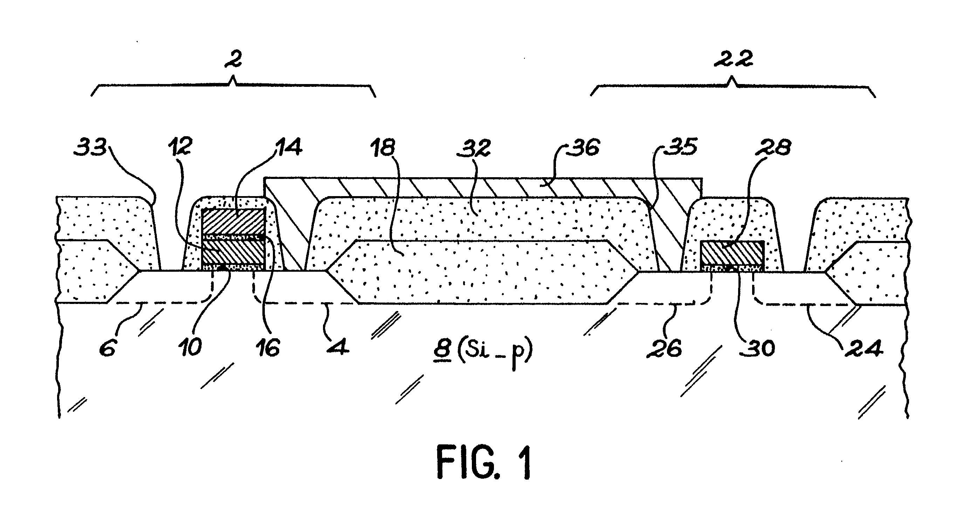

Sur la figure 1, on a représenté, en coupe longitudinale, une partie d'une mémoire EPROM montrant une cellule mémoire et un circuit périphérique de commande.

Le point mémoire portant la référence générale 2 est formé d'un transistor comprenant une source 4 et un drain 6 réalisés dans un substrat 8 en silicium monocristallin. La source 4 et le drain 5 présentent des conductivités, par exemple de type n$^+$, différentes de celle du substrat 8, par exemple de type p. Ce transistor 2 comprend de plus un isolant de grille 10, généralement en oxyde de silicium, sur lequel sont empilées une première grille 12 et une seconde grille 14, généralement réalisées en silicium polycristallin dopé, ces deux grilles étant séparées par une fine couche d'isolant 16 généralement d'oxyde de silicium.

Ce point mémoire 2 est isolé électriquement, au moyen d'un oxyde de champ 18, réalisé généralement par oxydation localisée du substrat 8 en silicium (procédé LOCOS), d'un circuit périphérique, portant la référence générale 22.

Ce circuit périphérique 22 est formé d'un transistor à technologie conventionnelle, par exemple nMOS. Ce transistor 22 comprend une source 24 et un drain 26, réalisés dans le substrat en silicium 8, ayant de conductivités différentes de celle du substrat, par exemple de type n$^+$ pour un substrat du type p. Ce transistor 22 comprend de plus une unique grille 28, réalisée généralement en silicium polycristallin dopé, isolée du substrat par un isolant 30 généralement en oxyde de silicium.

L'ensemble de la structure, formé du point mémoire 2 et du circuit périphérique 22, est recouvert d'une couche épaisse d'oxyde de silicium 32, dans laquelle sont réalisés des trous de contact électrique tels que 35. Les connexions électriques entre les différents points mémoires de la mémoire EPROM et/ou les différents circuits périphériques sont assurées par une couche conductrice 36, généralement en aluminium, déposée sur la couche d'oxyde de silicium 32 et gravée selon un motif désiré. Sur la figure 1, on a représenté, par exemple, une connection entre la source du point mémoire 2 et le drain du circuit de commande 22.

Dans les circuits intégrés, et en particulier dans une mémoire EPROM, les différentes couches de matériau constituant ces circuits ont une épaisseur bien précise. En particulier, l'épaisseur de l'oxyde de grille 10 des points mémoires 2, l'épaisseur de l'oxyde inter-grille 16 du point mémoire 2 et l'épaisseur de l'oxyde de grille 30 du transistor de commande 22 ont une épaisseur différente bien précise. L'épaisseur de l'oxyde de grille 10 est par exemple comprise entre 20 et 30 nm, l'épaisseur de l'oxyde inter-grille 16 est par exemple comprise entre 30 et 40 nm et l'épaisseur de l'oxyde de grille 30 est par exemple comprise entre 30 et 40 nm. Ces différentes épaisseurs d'oxyde posent un problème d'optimisation simultanée lors de leur fabrication.

On va décrire, ci-dessous un procédé de fabrication d'une mémoire EPROM, selon l'art antérieur, au niveau d'un point mémoire et d'un circuit périphérique, étant entendu que ce procédé permet de réaliser simultanément tous les points mémoires et tous les circuits périphériques de cette mémoire.

Conformément à l'art antérieur, après formation de l'oxyde d'isolement 18, on réalise l'oxyde de grille 10 du point mémoire 2, généralement par oxydation thermique du substrat en silicium 8, puis on dépose une première couche de silicium polycristallin dopé dans laquelle on réalise par gravure la première grille 12 du point mémoire 2. On réalise ensuite, généralement par oxydation thermique du substrat 8 en silicium et simultanément, l'oxyde de grille 30 du circuit périphérique 22 et l'oxyde intergrille 16 du point mémoire 2.

Pour obtenir un bon rapport d'épaisseur entre l'oxyde de grille 30 et l'oxyde intergrille 16, on essaie de trouver des conditions d'oxydation thermique adéquates. Malheureusement, ces conditions sont généralement difficiles à trouver et à mettre en oeuvre.

Après la réalisation simultanée de l'oxyde de grille 30 et de l'oxyde intergrille 16, on dépose sur l'ensemble de la structure, une deuxième couche de silicium polycristallin, puis on grave cette couche afin de réaliser la seconde grille 14 du point mémoire 2 et la grille 28 du circuit périphérique. L'ensemble de la structure est ensuite recouvert de la couche isolante 32 que l'on grave pour former les trous de contact électrique.

Ce problème d'optimisation simultanée de différentes épaisseurs d'oxyde de silicium et de façon générale de couches d'isolant situées à un même niveau dans les circuits intégrés, se pose dans d'autres circuits que les mémoires EPROM et en particulier dans les circuits comportant un empilement de plusieurs grilles en silicium polycristallin tels que les mémoires EEPROM (mémoire à lecture seule programmable et effaçable électriquement), SRAM (mémoire à accès aléatoire statique), DRAM (mémoire à accès aléatoire dynamique).

La présente invention a justement pour objet un nouveau procédé de fabrication d'un circuit intégré comportant un empilement de deux grilles isolées électriquement, permettant de remédier à l'inconvénient ci-dessus. Ce procédé est basé sur la réalisation successive et indépendante des différentes couches d'isolant situées à un même niveau, entrant dans la constitution de deux composants distincts du circuit intégré.

De façon plus précise, l'invention a pour objet un procédé de fabrication, sur un substrat semiconducteur, d'un circuit intégré comprenant au moins deux composants distincts isolés électriquement, un premier composant comportant un premier isolant surmonté d'une première et d'une seconde grilles empilées, séparées par un second isolant, et un second composant comportant un troisième isolant surmonté d'une troisième grille, le premier, le deuxième et le troisième isolants ayant des épaisseurs différentes et bien définies, caractérisé en ce qu'il comprend les étapes suivantes :

a) - réalisation sur le substrat d'une couche de premier isolant,

b) - recouvrement de la couche de premier isolant d'une première couche conductrice dans laquelle sera réalisée la première grille,

c) - réalisation sur la première couche conductrice d'une couche de second isolant,

d) - réalisation d'une première gravure de la couche de second isolant et de la première couche conductrice afin de ne garder du second isolant et du matériau conducteur que dans la région dans laquelle sera réalisé le premier composant,

e) - élimination de la région de la couche de premier isolant située à l'endroit où sera réalisé le second composant,

f) - réalisation d'une couche de troisième isolant dans ledit emplacement, et éventuellement sur les flancs gravés de la première couche conductrice,

g) - recouvrement de la structure obtenue d'une seconde couche conductrice,

h) - réalisation de la seconde et de la troisième grilles par gravure de la seconde couche conductrice, et

i) - réalisation de la première grille à l'aide d'une seconde gravure de la couche de second isolant et de la première couche conductrice.

La réalisation successive et indépendante, selon l'invention, du premier, du second et du troisième isolants, permet une bonne maîtrise de leur épaisseur.

Le procédé selon l'invention présente l'avantage d'être simple à mettre en oeuvre.

Il s'applique avantageusement à la fabrication d'une mémoire EPROM formée de plusieurs cellules de mémoire et de plusieurs circuits périphériques de commande isolés électriquement les uns des autres.

De façon à conserver intacte l'épaisseur du second isolant, lors du dépôt de la couche de troisième isolant, on dépose de façon avantageuse sur la couche de second isolant une couche protectrice, par exemple en nitrure de silicium, et en réalise l'étape d) en gravant aussi cette couche de protection. Si cette couche protectrice est aussi un bon diélectrique, elle peut être conservée dans la suite du procédé et s'associer au second isolant pour former une structure isolante, intergrille, bicouche. Dans le cas contraire, cette couche de protection est éliminée avant de réaliser le dépôt de la second couche conductrice.

Selon un mode préféré de mise en oeuvre du procédé de l'invention, le substrat semiconducteur est du silicium monocristallin. De même, la première et/ou la seconde couches conductrices sont réalisées en silicium polycristallin dopé.

Par ailleurs, le premier, le second et/ou le troisième isolants sont réalisés de préférence en oxyde de silicium. Pour un substrat en silicium, on réalise par exemple le premier isolant et le troisième isolant par oxydation thermique du substrat. De même, pour une première couche conductrice en silicium polycristallin, on réalise le second isolant par oxydation thermique de cette couche conductrice.

D'autres caractéristiques et avantages de l'invention ressortiront mieux de la description qui va suivre, donnée à titre illustratif et non limitatif.

La description est faite en référence aux figures annexées dans lesquelles :

- la figure 1, déjà décrite, représente schématiquement, en coupe longitudinale, un point mémoire et un circuit périphérique d'une mémoire EPROM, et
- les figures 2 à 8 représentent schématiquement, en coupe longitudinale, un exemple de fabrication, selon l'invention, d'une mémoire EPROM.

Le procédé de fabrication selon l'invention va être décrit au niveau d'un point mémoire et d'un circuit périphérique d'une mémoire EPROM, tels que représentés sur la figure 1, mais bien entendu, ce procédé permet de fabriquer simultanément tous les points mémoires et circuits périphériques d'une telle mémoire.

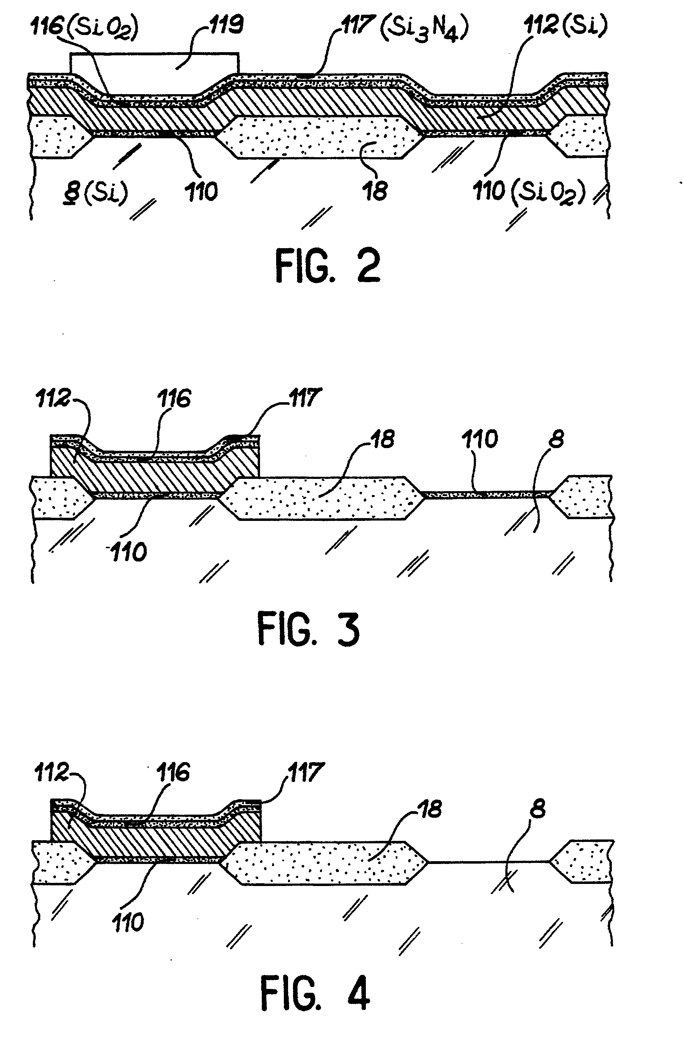

La première étape du procédé selon l'invention, comme représenté sur la figure 2, consiste à réaliser dans un substrat en silicium monocristallin 8, par exemple de type p, un oxydation localisée dudit substrat afin de former l'oxyde de champ 18 de la mémoire EPROM selon la technologie LOCOS bien connue de l'homme de l'art.

On recouvre ensuite la surface de substrat 8 d'une première couche isolante 110 de préférence en oxyde de silicium ($SiO_2$) dans laquelle sera formé l'isolant de grille 10 (figure 1) d'un point mémoire 2 de la mémoire EPROM. Cette couche d'oxyde 100 est réalisée notamment par oxydation thermique du substrat. Une oxydation thermique effectuée par exemple à 950°C, pendant 30 mn, permet de former une couche d'oxyde de 25 nm environ d'épaisseur.

L'étape suivante du procédé consiste à recouvrir l'ensemble de la structure obtenue par une première couche conductrice 112, dans laquelle sera réalisée la première grille 12 d'un point mémoire 2 (figure 1) de la mémoire EPROM. Cette couche 112 est réalisée de préférence en silicium polycristallin de type N, notamment dopé au phosphore ; elle peut présenter une épaisseur de l'ordre de 400 nm. Cette couche 112 de silicium polycristallin peut être obtenue par exemple par un procédé de dépôt chimique en phase vapeur, à basse pression.

On recouvre alors la couche conductrice 112 d'une seconde couche isolante 116, dans laquelle sera réalisé l'isolant intergrille 16 d'un point mémoire 2 (figure 1) de la mémoire. Cette couche isolante 116 est réalisée de préférence en oxyde de silicium ($SiO_2$) et présente une épaisseur de 30 nm. Lorsque la couche conductrice 112 est réalisée en silicium polycristallin, la couche 116 en oxyde de silicium peut être obtenue par oxydation thermique du silicium polycristallin. Cette oxydation est réalisée par exemple à 950°C, pendant 30 mn.

La couche isolante 116 est ensuite recouverte d'une couche protectrice 117 permettant de conserver intacte l'épaisseur de la couche 116 de second isolant lors de la réalisation, notamment par oxydation thermique du substrat en silicium 8, de la couche de troisième isolant. Cette couche 117 est réalisée de préférence en nitrure de silicium ($Si_3N_4$). Cette couche de nitrure, présentant une épaisseur de l'ordre de 10 nm, peut être, obtenue par exemple par un procédé de dépôt chimique en phase vapeur à basse pression.

L'étape suivante du procédé consiste à réaliser, selon le procédé classique de la photolithographie, un masque de résine 119. Ce masque 119 permet de ne masquer l'empilement des couches 117, 116 et 112 que dans la région dans laquelle sera réalisé le point mémoire 2.

Après réalisation du masque 119, on élimine successivement, comme représenté sur la figure 3, les parties de la couche protectrice 117, de la couche isolante 116 et de la couche conductrice 112 non recouvertes de résine. Ces gravures successives permettent de mettre à nu la région de la couche isolante 110 située à l'emplacement du circuit de commande 22 (figure 1) de la mémoire EPROM à réaliser. Ces gravures peuvent être effectuées de façon anisotrope par des procédés de gravure ionique réactive en utilisant comme agent d'attaque de l'hexafluorure de soufre ($SF_6$) pour une couche 117 en nitrure de silicium et une couche 112 en silicium polycristallin et du trifluorométhane ($CHF_3$) ou du tétrafluorure de carbone ($CF_4$) pour une couche 116 en oxyde de silicium.

Après élimination du masque de résine 119 par attaque chimique, par exemple avec un solution d'acide nitrique fumant pour une résine photosensible positive, on élimine, comme représenté sur la figure 4, la région de la couche 110 mise à nu, se trouvant à l'emplacement de l'isolant de grille 30 (figure 1) à réaliser du circuit périphérique 22 de la mémoire EPROM. Cette élimination de la couche 110 peut être réalisée par une attaque chimique en utilisant de l'acide fluorohydrique pour une couche 110 en oxyde de silicium. Cette élimination permet de mettre à nu la partie du substrat 8 dans laquelle sera réalisé le circuit de commande 22 de la mémoire EPROM.

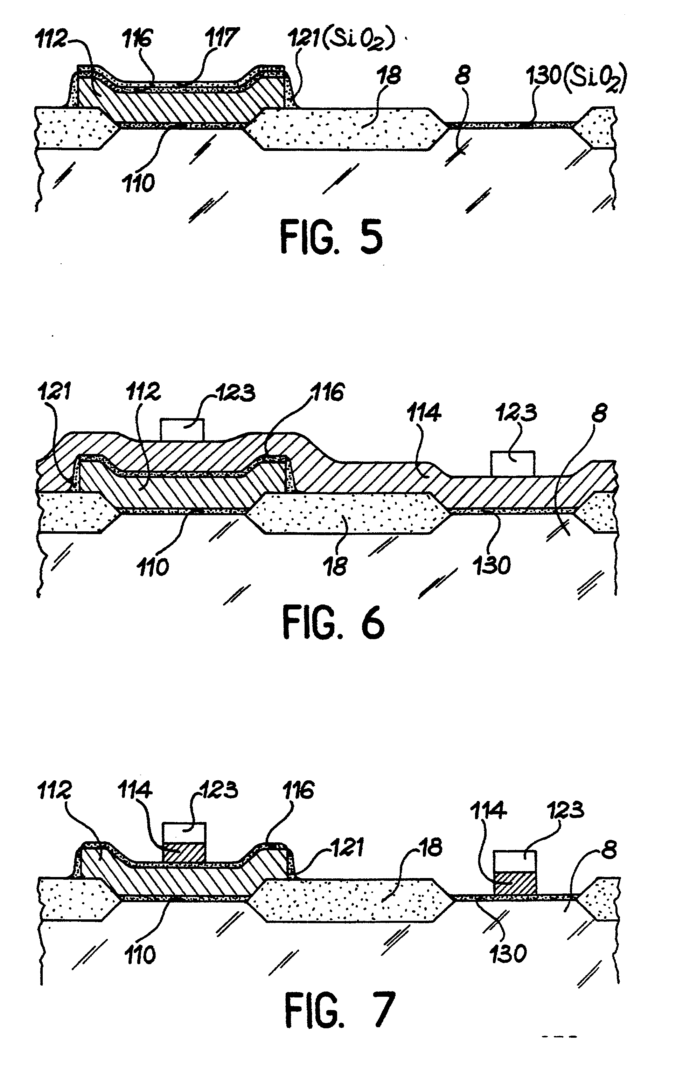

L'étape suivante du procédé consiste à former, comme représenté sur la figure 5, une couche d'isolant 130 sur la région du substrat mise à nu, couche isolante dans laquelle sera réalisé l'isolant de grille 30 (figure 1) du transistor de commande 22 de la mémoire EPROM. Cette couche d'isolant 130 est réalisée de préférence en oxyde de silicium et présente une épaisseur de l'ordre de 40 nm. Elle est obtenue de préférence par oxydation thermique du substrat en silicium mis à nu 8, la couche protectrice 117 gravée servant de masque à cette oxydation thermique. Cette oxydation peut être réalisée à 950°C, pendant 40 mn.

Lorsque la première couche 112, dans laquelle on a réalisé la première grille 12 (figure 1) de la cellule mémoire 2 de la mémoire EPROM est en silicium polycristallin, cette étape d'oxydation thermique entraîne la formation de flancs isolants 121 en oxyde de silicium dans la région de la cellule mémoire.

L'étape suivante du procédé consiste à éliminer éventuellement la couche protectrice gravée 117 par exemple par attaque chimique en phase humide en utilisant une solution d'acide orthophosphorique pour une couche en nitrure de silicium.

On réalise ensuite, comme représenté sur la figure 6, le recouvrement de l'ensemble de la structure obtenue d'une deuxième couche conductrice 114 dans laquelle sera réalisé la second grille 14 (figure 1) du point mémoire 2 et l'unique grille 28 du circuit périphérique 22 de la mémoire EPROM.

Cette couche conductrice 114 est réalisée de préférence en silicium polycristallin, dopé au phosphore et présente une épaisseur de l'ordre de 50 nm. Elle peut être réalisée par un procédé de dépôt chimique en phase vapeur à basse pression.

L'étape suivante du procédé consiste à réaliser, selon les procédés classiques de la photolithographie, un masque de résine 123 représentant l'image de la première grille 12 ou de la seconde grille 14 du point mémoire 2 (figure 1) et l'image de la grille 28 du circuit de commande 22. Autrement dit, seules les régions de la couche conductrice 114 situées à l'emplacement des grilles des transistors 2 et 22 sont recouvertes de résine.

A travers ce masque 123, on effectue ensuite, comme représenté sur la figure 7, une gravure de la couche conductrice 114 afin d'éliminer les régions de cette couche 114 non masquées de résine et donc de réaliser la seconde grille 14 du point mémoire et la grille 28 du circuit de commande. Cette gravure peut être réalisée de façon anisotrope par un procédé de gravure ionique réactive en utilisant comme agent d'attaque de l'hexafluorure de soufre pour une couche conductrice en silicium polycristallin.

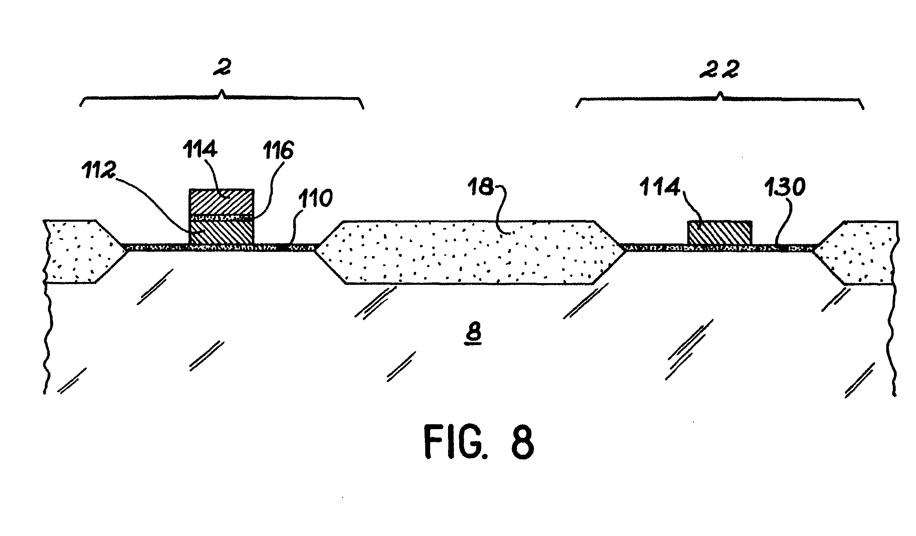

A l'aide du masque de résine 123, on réalise ensuite la première grille 12 autoalignée sous la deuxième grille 14 en effectuant, comme représenté sur la figure 8, une deuxième gravure des couches isolante 116 et conductrice 112 en vue d'éliminer les régions non masquées de ces couches. Pendant cette étape de gravure, le circuit périphérique 22 est protégé par un masque de résine pour éviter de graver le silicium monocristallin.

Ces gravures successives peuvent être effectuées de façon anisotrope par des procédés de gravure ionique réactive en utilisant comme agent d'attaque de l'hexafluorure de soufre pour une couche 112 en silicium polycrystallin et du trifluorométhane pour la couche 116 en oxyde de silicium.

On élimine ensuite, par attaque chimique le masque de résine 123 et la résine de protection du circuit périphérique par exemple avec une solution d'acide nitrique pour une résine photosensible positive. La structure obtenue est alors celle représentée sur la figure 1.

Les sources et drains du point mémoire 2 et du circuit périphérique 22 sont réalisés ensuite de façon classique, en implantant des ions notamment de phosphore ou d'arsenic dans le substrat 8 de type p, les grilles empilées 12 et 14 du point mémoire 2 et la grille 28 du circuit périphérique 22 servant de masque à cette implantation.

L'isolation finale et les lignes d'interconnexion de la mémoire EPROM sont réalisées comme dans l'art antérieur.

Le procédé selon l'invention a été décrit dans le cadre de la fabrication d'une mémoire EPROM, mais bien entendu, ce procédé est d'application beaucoup plus générale. En effet, il s'applique à tout circuit intégré comportant deux types de composants distincts isolés électriquement l'un de l'autre, l'un des composants comprenant un premier isolant surmonté d'une première grille et d'une seconde grille empilées, sépa rées l'une de l'autre par un second isolant, l'autre composant comprenant un troisième isolant surmonté d'une troisième grille. Ces trois isolants doivent présenter des épaisseurs différentes et bien définies.

Dans l'exemple de fabrication d'une mémoire EPROM décrite précédemment, il est possible d'effectuer quelques modifications sans pour autant sortir du cadre de l'invention. En particulier, il est possible de modifier la nature et l'épaisseur des différentes couches conductrices et isolantes du circuit intégré ainsi que leur procédé de dépôt et de gravure. Par exemple, les couches conductrices 112 et 114 peuvent aussi être réalisées en un métal réfractaire tel que le molybdène, le tantale, le titane ou le tungstène ou bien en un siliciure de l'un de ces métaux. De même, les couches isolantes d'oxyde de silicium peuvent être remplacées par des couches de nitrure de silicium.

En ce qui concerne la couche protectrice 117, celle-ci peut être réalisée en autre chose qu'en nitrure de silicium dans la mesure où elle garde sa propriété de masque, lors de la réalisation de la couche 130 notamment par oxydation du substrat. De plus, si cette couche de protection 117 comporte de bonnes qualités diélectriques, elle peut être gardée et utilisée comme diélectrique entre les deux grilles de chaque cellule mémoire, au lieu d'être éliminée après réalisation de la couche isolante 130. Dans ce cas, elle s'associe au second isolant du point mémoire pour former une structure isolante bicouche, intergrille, notamment en oxyde de silicium + nitrure de silicium.

Le procédé de fabrication selon l'invention est facile à mettre en oeuvre. Il permet aisément d'optimiser les épaisseurs des isolants d'un circuit intégré situés notamment au même niveau dans ledit circuit.

## Revendications

1. Procédé de fabrication, sur un substrat semiconducteur (8), d'un circuit intégré comprenant au moins deux types de composants distincts isolés électriquement, un premier composant (2) comportant un premier isolant (10) surmonté d'une première (12) et d'une seconde (14) grilles empilées, séparées par un second isolant (16), et un second composant (22) comportant un troisième isolant (30) surmonté d'une troisième grille (28), le premier (10), le second (16) et le troisième (30) isolants ayant des épaisseurs différentes et bien définies, caractérisé en ce qu'il comprend les étapes suivantes :

a) - réalisation sur le substrat (8) d'une couche (110) de premier isolant,

b) - recouvrement de la couche (110) de premier isolant d'une première couche conductrice (112) dans laquelle sera réalisée la première grille (12),

c) - réalisation sur la première couche conductrice (112) d'une couche (116) de second isolant,

d) - réalisation d'une première gravure de la couche (116) de second isolant et de la première couche conductrice (112) afin de ne garder du second isolant et du matériau conducteur que dans la région dans laquelle sera réalisé le premier composant,

e) - élimination de la région de la couche (110) de premier isolant située à l'endroit où sera réalisé le second composant,

f) - réalisation d'une couche (130) de troisième isolant dans ledit emplacement,

g) - recouvrement de la structure obtenue d'une seconde couche conductrice (114),

h) - réalisation de la seconde (14) et de la troisième (28) grilles par gravure de la seconde couche conductrice (114), et

i) - réalisation de la première grille (12) à l'aide d'une seconde gravure de la couche (116) de second isolant et de la première couche conductrice (112).

2. Procédé de fabrication selon la revendication 1, caractérisé en ce que l'on dépose sur la couche (116) de second isolant une couche protectrice (117) et en ce que l'on réalise l'étape d) en gravant aussi cette couche de protection (117).

3. Procédé de fabrication selon la revendication 2, caractérisé en ce que l'on élimine la couche protectrice (117) gravée avant de réaliser l'étape g).

4. Procédé de fabrication selon la revendication 2, caractérisé en ce que l'on garde la couche protectrice (117).

5. Procédé de fabrication selon l'une quelconque des revendications 2 à 4, caractérisé en ce que la couche protectrice (117) est une couche de nitrure de silicium.

6. Procédé de fabrication selon l'une quelconque des revendications 1 à 5, caractérisé en ce que le substrate semiconducteur (8) est du silicium monocristallin.

7. Procédé de fabrication selon l'une quelconque des revendications 1 à 6, caractérisé en ce que la première (112) et/ou la seconde (114) couches conductrices sont réalisées en silicium polycristallin.

8. Procédé de fabrication selon l'une quelconque des revendications 1 à 7, caractérisé en ce que le premier (10), le second (16) et/ou le troisième (30) isolants sont réalisés en oxyde de silicium.

9. Procédé de fabrication selon la revendication 8, caractérisé en ce que le substrat (8) étant en silicium, on réalise l'étape a) et/ou l'étape f) par oxydation thermique dudit substrat (8).

10. Procédé de fabrication selon la revendication 8, caractérisé en ce que la première couche conductrice (112) étant en silicium, on réalise l'étape c) par oxydation thermique de ladite première couche conductrice (112).

11. Procédé de fabrication d'une mémoire EPROM comprenant plusieurs cellules mémoires et plusieurs circuits périphériques de commande isolés électriquement les uns des autres, caractérisé en ce qu'il est conforme à l'une quelconque des revendications précédentes, les cellules mémoires (2) constituant lesdits premiers composants et les circuits périphériques (22) lesdits seconds composants.

**Patentansprüche**

1. Verfahren zur Herstellung einer integrierten Schaltung auf einem Halbleitersubstrat (8), die wenigstens zwei unterschiedliche, elektrisch isolierte Bauelemente enthält, ein erstes Bauelement (2), das einen ersten Isolator (10) aufweist, der von einer ersten (12) und von einer zweiten (14) übereinander angeordneten Steuerelektrode bedeckt ist, die von einem zweiten Isolator (16) voneinander getrennt sind, und ein zweites Bauelement (22), das einen dritten Isolator (30) aufweist, der von einer dritten Steuerelektrode (28) bedeckt ist, wobei der erste (10), der zweite (16) und dritte (30) Isolator voneinander verschiedene und vorbestimmte Dicken aufweisen, dadurch gekennzeichnet, daß es die folgenden Schritte umfaßt:

a) Ausbilden einer ersten Isolierschicht (110) auf dem Substrat (8),

b) Bedecken der ersten Isolierschicht (110) mit einer ersten Leiterschicht (112), in der die erste Steuerelektrode (12) ausgebildet werden soll,

c) Ausbilden einer zweiten Isolierschicht (116) auf der ersten Leiterschicht (112),

d) Ausführen einer ersten Ätzung der zweiten Isolierschicht und der ersten Leiterschicht (112) derart, daß der zweite Isolator und das Leitermaterial nur in dem Bereich zurückbleiben, in dem das erste Bauelement ausgebildet werden soll,

e) Beseitigen des Bereichs der ersten Isolierschicht (110), der an der Stelle liegt, wo das zweite Bauelement hergestellt werden soll,

f) Ausbilden einer dritten Isolierschicht (130) an der genannten Stelle,

g) Bedecken der erhaltenen Struktur mit einer zweiten Leiterschicht (114),

h) Ausbilden der zweiten (14) und der dritten (28) Steuerelektrode durch Ätzung der zweiten Leiterschicht (114), und

i) Ausbilden der ersten Steuerelektrode (12) mit Hilfe einer zweiten Ätzung der zweiten Isolierschicht (116) und der ersten Leiterschicht (112).

2. Herstellungsverfahren nach Anspruch 1, dadurch gekennzeichnet, daß man auf die zweite Isolierschicht (116) eine Schutzschicht (117) aufbringt und daß man den Schritt d) dadurch ausführt, daß man auch diese Schutzschicht (117) ätzt.

3. Herstellungsverfahren nach Anspruch 2, dadurch gekennzeichnet, daß man die geätzte Schutzschicht (117) beseitigt, bevor der Schritt g) ausgeführt wird.

4. Herstellungsverfahren nach Anspruch 2, dadurch gekennzeichnet, daß man die Schutzschicht (117) beibehält.

5. Herstellungsverfahren nach einem der Ansprüche 2 bis 4, dadurch gekennzeichnet, daß die Schutzschicht (117) eine Siliciumnitridschicht ist.

6. Herstellungsverfahren nach einem der Ansprüche 1 bis 5, dadurch gekennzeichnet, daß das Halbleitersubstrat (8) aus monokristallinem Silicium besteht.

7. Herstellungsverfahren nach einem der Ansprüche 1 bis 6, dadurch gekennzeichnet, daß die erste (112) und/oder die zweite (114) Leiterschicht aus polykristallinem Silicium hergestellt werden.

8. Herstellungsverfahren nach einem der Ansprüche 1 bis 7, dadurch gekennzeichnet, daß der erste (10), der zweite (16) und/oder der dritte (30) Isolator aus Siliciumoxid hergestellt werden.

9. Herstellungsverfahren nach Anspruch 8, dadurch gekennzeichnet, daß wenn das Substrat (8) Silicium ist, man den Schritt a) und/oder den Schritt f) durch thermische Oxidation des Substrats (8) ausführt.

10. Herstellungsverfahren nach Anspruch 8, dadurch gekennzeichnet, daß wenn die erste Leiterschicht (112) aus Silicium besteht, man den Schritt c) durch thermische Oxidation der genannten ersten Leiterschicht (112) ausführt.

11. Herstellungsverfahrenn für einen EPROM-Speicher, der mehrere Speicherzellen und mehrere periphere Steuerschaltungen enthält, die elektrisch voneinander isoliert sind, dadurch gekennzeichnet, daß es in Übereinstimmung mit einem der vorhergehenden Ansprüche ist, wobei die Speicherzellen (2) die genannten ersten Bauelemente und die peripheren Schaltungen (22) die genannten zweiten Bauelemente bilden.

**Claims**

1. Process for the production, on a semiconductor substrate (8), of an integrated circuit having at least two separate electrically insulated components, a first component (2) having a first insulant (10) surmounted by first (12) and second (14) stacked gates, which are separated by a second insulant (16), and a second component (22) having a third insulant (30) surmounted by a third gate (28), the first (10), second (16) and third (30) insulants having different, clearly defined thicknesses, characterized in that it comprises the following stages:

a) producing a first insulant layer (110) on the substrate (8),

b) covering the first insulant layer (110) with a first conductive layer (112), in which the first gate (12) will be formed,

c) formation of a second insulant layer (112) on the first conductive layer (116),

d) carrying out a first etching of the second insulant layer (116) and the first conductive layer (112) so as to only retain said second insulant and said conductive material in the region in which the first component will be produced,

e) elimination of the first insulant layer (110) region located at the point where the second component will be produced,

f) producing a third insulant layer (130) in said location,

g) covering the structure obtained with a second conductive layer (114),

h) producing the second (14) and third (28) gates by etching the second condtuctive layer (114) and

i) producing the first gate (12) with the aid of a second etching of the second insulant layer (116) and the first conductive layer (112).

2. Production process according to claim 1, characterized in that a protective layer (117) is deposited on the second insulant layer (116) and wherein stage d) is performed by also etching said protective layer (117).

3. Production process according to claim 2, characterized in that the etched protective layer (117) is eliminated before performing stage g).

4. Production process according to claim 2, characterized in that the protective layer (117) is retained.

5. Production process according to any one of the claims 2 to 4, characterized in that the protective layer (17) is a silicon nitride layer.

6. Production process according to any one of the claims 1 to 5, characterized in that the semiconductor substrate (8) is of monocrystalline silicon.

7. Production process according to any one of the claims 1 to 6, characterized in that the first (112) and/or second (114) conductive layers are of polycrystalline silicon.

8. Production process according to any one of the claims 1 to 7, characterized in that the first (10), second (16) and/or third (30) insulants are of silicon dioxide.

9. Production process according to claim 8, characterized in that with the substrate (8) being made from silicon, stage a) and/or stage f) are performed by thermally oxidizing said substrate (8).

10. Production process according to claim 8, characterized in that as the first conductive layer (112) is of silicon, stage c) is performed by thermally oxidizing said first conductive layer (112).

11. Process for producing en EPROM incorporating several storage cells and several peripheral control circuits which are electrically insulated from one another, characterized in that it is in accordance with any one of the preceding claims, the storage cells (2) constituting said first components and the peripheral circuits (22) constituting said second components.

FIG. 1

EP 0 206 929 B1

116 (SiO₂)    119    117 (Si₃N₄)    112 (Si)

8 (Si)    110    18    110 (SiO₂)

FIG. 2

112    116    117

18    110    8

110

FIG. 3

112    116    117

18    8

110

FIG. 4

FIG. 5

FIG. 6

FIG. 7

FIG. 8

EP 0 206 929 B1